# EUROPÄISCHE PATENTANMELDUNG

(11) **EP 4 576 955 A1**
(43) Veröffentlichungstag der Anmeldung: **25.06.2025**
(21) Anmeldenummer: 23219363.1
(22) Anmeldetag: 21.12.2023
(51) Int. Cl.: H05K 5/06, H05K 7/14, H05K 5/02

(54) **AUTOMATISIERUNGSKOMPONENTE**

(71) Anmelder: Siemens Aktiengesellschaft, 80333 München (DE)
(72) Erfinder: Görlich, Stefan, 92278 Illschwang (DE); Hubmann, Stefan, 92237 Sulzbach-Rosenberg (DE)
(74) Vertreter: Siemens Patent Attorneys

(57) **Zusammenfassung**

Um den Hygieneanforderungen gerecht zu werden wird eine Automatisierungskomponente (10) für die industrielle Automatisierung bereitgestellt, welche eine erste Fläche (F1) und eine zweite Fläche (F2) an einer Mittellinie (M), welche durch die Mittelpunkte (MP) der ersten Befestigungsöffnung (21) und der zweiten Befestigungsöffnung (22) verläuft, einstückig und nahtlos aneinander angeordnet sind, die Mittellinie (M) ist damit als First des Oberteils (1) ausgebildet, das Oberteil (1) ist ausgestaltet, dass sich die erste Fläche (F1) ausgehend von der Mittellinie (M) bis zu einer ersten Traufkante (TK1) und die zweite Fläche (F2) ausgehend von der Mittellinie (M) bis zu einer zweiten Traufkante (TK2) jeweils als eine schiefe Ebene erstreckt, wobei in der ersten Fläche (F1) und in der zweiten Fläche (F2) die Anschlüsse (DA1,...,DA8) derart ausgestaltet sind, dass jeweils für einen Anschluss (DA1,...,DA8) in den Flächen (F1,F2) bzw. in dem Oberteil (1) ein Gewinde (G) integriert ist und um das Gewinde (G) ist eine kreisrunde Kontaktfläche (K) in der Ausgestaltung eines Hohl-Zylinders (HZ) angeordnet, der Hohl-Zylinder (HZ) wiederum ist derart in der schiefen Ebene angeordnet, dass seine Symmetrieachse (SA) des Hohl-Zylinders (HZ) vertikal verläuft, wobei dadurch für einen einzuschraubenden Schraubsteckverbinder (S) für den Datenanschluss (DA1,...,DA8) die Kontaktfläche (K) als eine ebene, ringförmige Kontaktfläche (K) ausgestaltet ist, auf der der Schraubsteckverbinder (S) mit einer hygienegerechten Dichtung abdichten kann.

## Beschreibung

Die Erfindung betrifft eine Automatisierungskomponente für die industrielle Automatisierung aufweisend ein Gehäuse umfassend ein Oberteil und ein Unterteil, wobei das Oberteil und das Unterteil derart ausgestaltet sind, dass zum Befestigen der Automatisierungskomponente an einer Montagefläche das Gehäuse eine erste Befestigungsöffnung und eine zweite Befestigungsöffnung aufweist, wobei in dem Oberteil eine Mehrzahl an Datenanschlüssen angeordnet sind, wobei die Datenanschlüsse ausgestaltet sind Schraubsteckverbinder aufzunehmen.

Beispielsweise bei einem Einsatz von Automatisierungsgeräten in medizinischen Bereichen oder in der Nahrungs- und Genussmittelindustrie bestehen an die dort eingesetzten Geräte besondere Anforderungen hinsichtlich der hygienischen Bedingungen. Diese Anforderungen beziehen sich im Wesentlichen auf die Reinigbarkeit der eingesetzten Geräte.

Nach dem Stand der Technik sind folgende Automatisierungs-Geräte bzw. Komponenten bekannt:
Balluff Network Interface IO-Link BNI IOL-252-000-Z013 gemäß Montageanleitung.
Digital Module AXL E IOL DI16 M12 6P gemäß https://www.phoenixcontact.com/us/products/2702660.
SIMATIC ET 200AL, DI 8x 24 V DC, 8XM8, Degree of protection IP67 gemäß Datenblatt vom 21.05.2020 bzw. gemäß Gerätehandbuch A5E32349561-AD von 08/2021.

All diese bekannten Automatisierungskomponenten haben den Nachteil, dass mit ihren Daten-, Strom- und Signalanschlüssen bei gesteckten und eingeschraubten Schraubsteckverbinder eine umlaufende Schmutzsammelkante rund um den die Daten-, Strom- und Signalanschluss entsteht.

Es ist eine Aufgabe der Erfindung eine Automatisierungskomponente bereitzustellen, welche den Anforderungen der Lebensmittelindustrie bezüglich der Hygiene gerecht wird.

Die Aufgabe wird dadurch gelöst, dass das Oberteil flächig ausgestaltet ist, wobei eine erste Fläche und eine zweite Fläche an einer Mittellinie, welche durch die Mittelpunkte der ersten Befestigungsöffnung und der zweiten Befestigungsöffnung verläuft, einstückig und nahtlos aneinander angeordnet sind, die Mittellinie ist damit als First des Oberteils ausgebildet, das Oberteil ist ausgestaltet, dass sich die erste Fläche ausgehend von der Mittelinie bis zu einer ersten Traufkante und die zweite Fläche ausgehend von der Mittellinie bis zu einer zweiten Traufkante jeweils als eine schiefe Ebene erstreckt, wobei in der ersten Fläche und in der zweiten Fläche die Daten-, Strom- und Signalanschlüsse derart ausgestaltet sind, dass jeweils für einen Daten-, Strom- und Signalanschluss in den Flächen bzw. in dem Oberteil ein Gewinde integriert ist und um das Gewinde ist eine kreisrunde Kontaktfläche in der Ausgestaltung eines Hohl-Zylinders angeordnet, der Hohl-Zylinder wiederum ist derart in der schiefen Ebene angeordnet, das eine Symmetrieachse des Hohl-Zylinders vertikal verläuft, wobei dadurch für einen einzuschraubenden Schraubsteckverbinder für den Daten-, Strom- und Signalanschluss die Kontaktfläche als eine ebene, ringförmige Kontaktfläche ausgestaltet ist, auf der der Schraubsteckverbinder mit einer hygienegerechten Dichtung abdichten kann.

Das Oberteil ist mit Vorteil ähnlich einem Giebeldach ausgestaltet, vorzugsweise mit einer Neigung von größer gleich 3 Grad, wodurch Wasser leicht abfließen kann. Durch diese konstruktiven Maßnahmen werden Anhaftungen von Verunreinigungen und daraus folgende Kontaminationen der Automatisierungskomponente vermieden. Eine hygienegerechte Dichtung als Dichtelement schließt bündig mit der Außenfläche des Hohl-Zylinders ab und das Dichtelement ist an dieser Stelle in seiner Dicke etwas größer als eine entsprechende Aussparung am Schraubsteckverbinder, so dass im montierten Zustand zwischen der ringförmigen Kontaktfläche und dem Gegenlager der Aussparung am Schraubsteckverbinder das Dichtelement derart komprimiert angeordnet ist, dass sich dazwischen ein spaltfreier Übergang ausbildet.

Mit Vorteil ist das Gehäuse und damit das Oberteil und das Unterteil derart ausgestaltet, dass sich in einer Vorzugseinbaulage, bei welcher die Befestigungsöffnungen senkrecht übereinanderstehen, das Gehäuse ausgehend von der ersten Befestigungsöffnung sich in Richtung der zweiten Befestigungsöffnung verjüngt. Dadurch können Flüssigkeiten schnell abfließen.

Zur besseren Reinhaltung ist das Gehäuse derart ausgestaltet, dass alle Flächen derart geformt sind, dass Ablagerungen von Verunreinigungen vermieden oder minimiert werden. Also keine scharfen Kanten oder Vertiefungen.

Die Zeichnung zeigt ein Ausführungsbeispiel der Erfindung, dabei zeigt
- FIG 1: eine Automatisierungskomponente in perspektivischer Ansicht,
- FIG 2: das Oberteil der Automatisierungskomponente,
- FIG 3: das Oberteil der Automatisierungskomponente in einer anderen Ansicht,
- FIG 4: eine Schnittdarstellung des Oberteils und
- FIG 5: eine perspektivische Ansicht eines angeschraubten Schraubsteckverbinder an einen Datenanschluss.

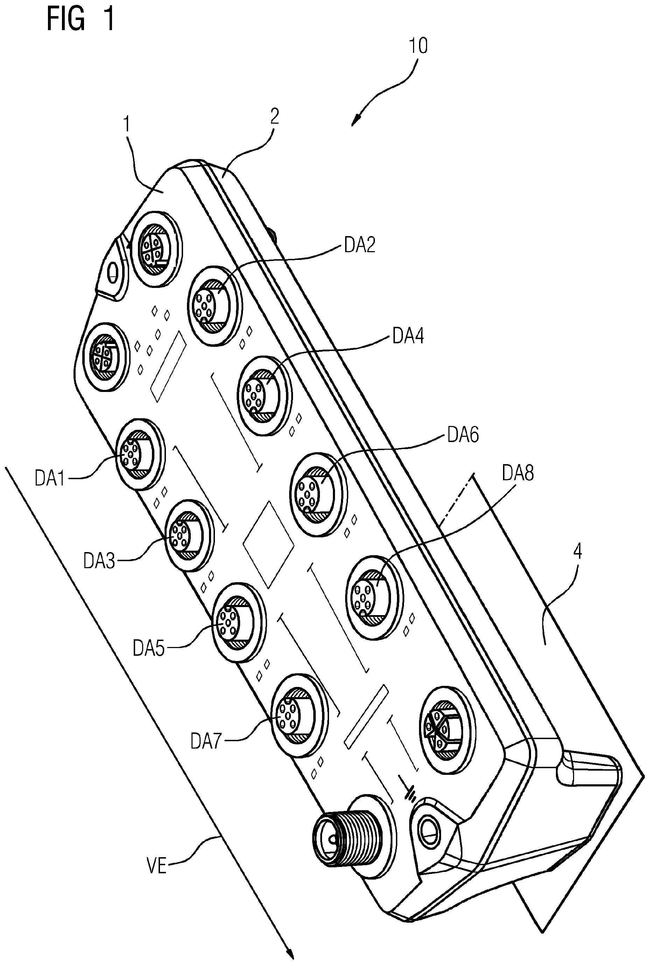

Gemäß FIG 1 ist eine Automatisierungskomponente 10 dargestellt. Die Automatisierungskomponente 10 ist als eine I/O-Baugruppe für die industrielle Automatisierung ausgestaltet. Die Automatisierungskomponente 10 weist ein Gehäuse 3 umfassend ein Oberteil 1 und ein Unterteil 2 auf. Das Oberteil 1 und das Unterteil 2 sind derart ausgestaltet, dass zum Befestigen der Automatisierungskomponente 10 an einer Montagefläche 4 des Gehäuses 3 eine erste Befestigungsöffnung 21 und eine zweite Befestigungsöffnung 22 aufweist. Das Oberteil 1 weist eine Mehrzahl an Anschlüssen (DA1,...,DA8) auf, im Wesentlichen wird hier auf die Signalanschlüsse für die Aktoren und Sensoren eingegangen, es gilt aber ebenso für Daten-, Strom- und Signalanschlüsse. Diese Anschlüsse (DA1,...,DA8) sind ausgestaltet, um Schraubsteckverbinder S aufzunehmen. Eine Vorzugseinbaurichtung VE sieht vor, die Automatisierungskomponente 10 an der als eine Wand ausgestaltete Montageflache 4 zu befestigen bzw. anzuschrauben.

Das Oberteil 1 ist flächig ausgestaltet, wobei eine erste Fläche F1 und eine zweite Fläche F2 an einer Mittellinie M angeordnet ist.

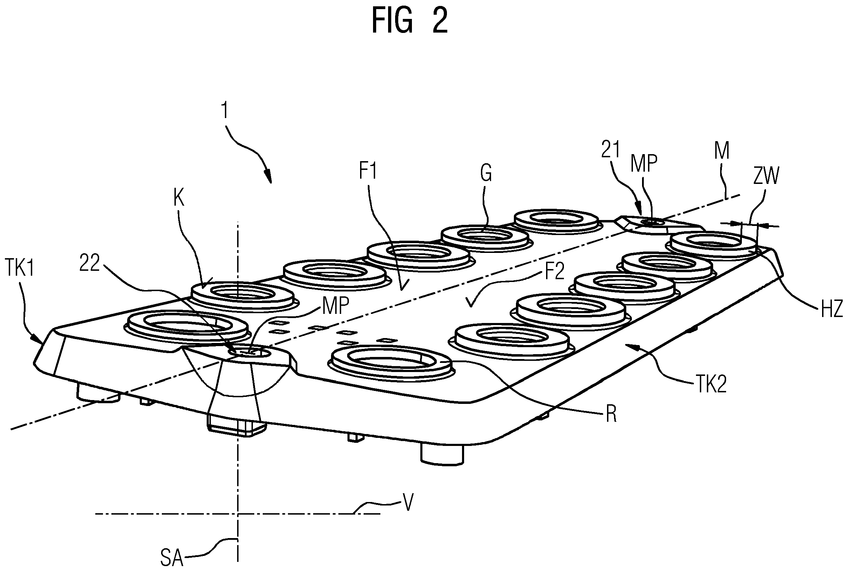

Die FIG 2 veranschaulicht diese Anordnung. Gemäß FIG 2 ist das Oberteil 1 ausgestaltet, das sich die erste Fläche F1 ausgehend von der Mittellinie M bis zu einer ersten Traufkante TK und die zweite Fläche F2 ausgehend von der Mittellinie M bis zu einer zweiten Traufkante TK jeweils als eine schiefe Ebene erstreckt.

In der ersten Fläche F1 und in der zweiten Fläche F2 sind die Anschlüsse (DA1,...,DA8) derart ausgestaltet, dass jeweils für einen Anschluss (DA1,...,DA8) in den Flächen F1,F2 ein Gewinde G integriert ist. Um das jeweilige Gewinde G ist eine kreisrunde Kontaktfläche K in der Ausgestaltung eines Hohl-Zylinders HZ angeordnet. Der Hohl-Zylinder HZ ist wiederum derart in der schiefen Ebene angeordnet, dass eine Symmetrieachse SA eines Hohl-Zylinders HZ vertikal verläuft. Dadurch gelingt es für einen einschraubbaren Schraubsteckverbinder S für den jeweiligen Anschluss (DA1,...,DA8) die Kontaktfläche K als eine Ebene, ringförmige Kontaktfläche K auszugestalten. Auf dieser Kontaktfläche K kann der Schraubsteckverbinder S mit einer hygienegerechten Dichtung D abdichten.

Der Hohl-Zylinder HZ ist derart in der Fläche F1,F2 angeordnet, dass die Kontaktfläche K sowohl zur Seite der Mittellinie M als auch zur Seite der Traufkante TK1,TK2 erhaben aus der Fläche F1,F2 heraussteht und einstückig mit der Fläche F1,F2 ausgebildet ist, wobei der Übergang des Hohl-Zylinders HZ zur Fläche F1,F2 mit einer Rundung R versehen ist.

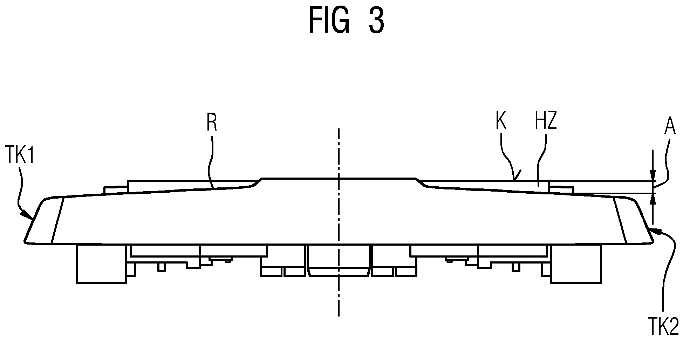

Mit der FIG 3 wird das erhabene Herausstehen des Hohl-Zylinders HZ noch einmal verdeutlicht. Der Abstand A zeigt das erhabene Herausstehen des Hohl-Zylinders HZ aus der Fläche F1,F2.

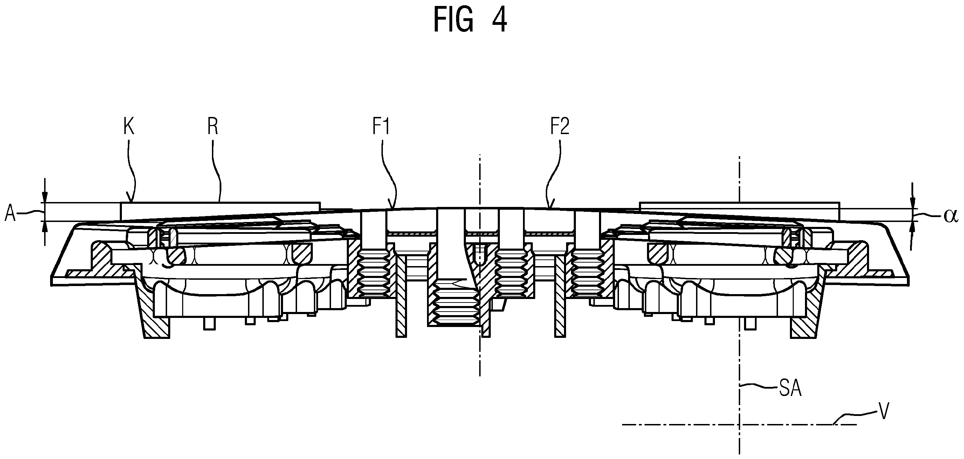

Eine alternative Ansicht bietet die FIG 4. Auch hier kann man bei der Schnittdarstellung gut sehen, dass die Kontaktfläche K des Hohl-Zylinders HZ mit dem Abstand A erhaben aus der ersten Fläche F1 bzw. der zweiten Fläche F2 heraussteht. Ausgehend von der Mittellinie M, welche als ein First für das Oberteil 1 betrachtet werden kann, weisen die erste Fläche F1 und die zweite Fläche F2 einen Neigungswinkel α und vorzugsweise 3 Grad oder größer auf.

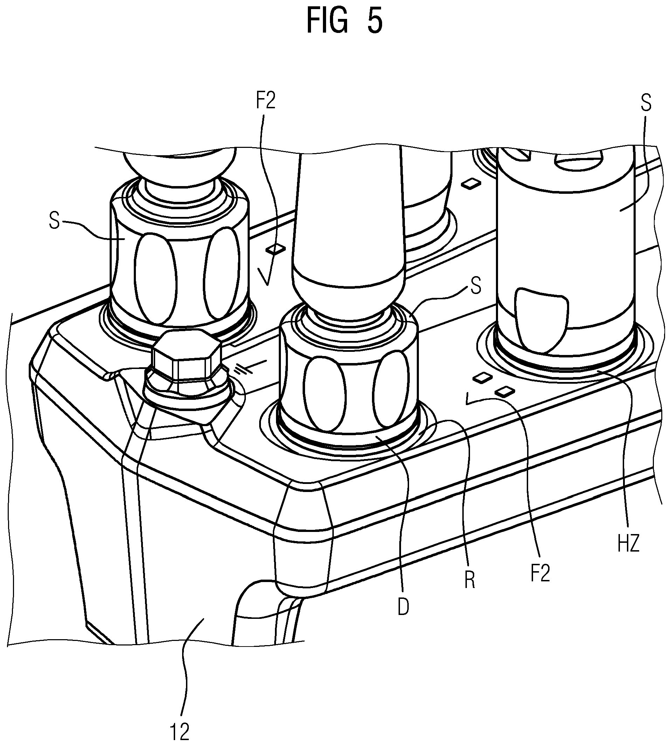

Mit der FIG 5 wird verdeutlicht, wie der Schraubsteckverbinder S auf der Kontaktfläche K mit seinem Dichtelement D angeordnet ist. Eine hygienegerechte Dichtung D als Dichtelement schließt bündig mit der Außenfläche des Hohl-Zylinders HZ ab und das Dichtelement D ist an dieser Stelle in seiner Dicke etwas größer als eine entsprechende Aussparung am Schraubsteckverbinder S, so dass im montierten Zustand zwischen der ringförmigen Kontaktfläche K und dem Gegenlager der Aussparung am Schraubsteckverbinder S das Dichtelement derart komprimiert angeordnet ist, dass sich dazwischen ein spaltfreier Übergang ausbildet.

## Patentansprüche

1. Automatisierungskomponente (10) für die industrielle Automatisierung aufweisend ein Gehäuse (3), umfassend ein Oberteil (1) und ein Unterteil (2), wobei das Oberteil (1) und das Unterteil (2) derart ausgestaltet sind, dass zum Befestigen der Automatisierungskomponente (10) an einer Montagefläche (4) das Gehäuse (3) eine erste Befestigungsöffnung (21) und eine zweite Befestigungsöffnung (22) aufweist, wobei in dem Oberteil (1) eine Mehrzahl an Anschlüssen (DA1,...,DA8) angeordnet sind, wobei die Anschlüsse (DA1,...,DA8) ausgestaltet sind Schraubsteckverbinder (S) aufzunehmen,
**dadurch gekennzeichnet, dass**
das Oberteil (1) flächig ausgestaltet ist, wobei eine erste Fläche (F1) und eine zweite Fläche (F2) an einer Mittellinie (M), welche durch die Mittelpunkte (MP) der ersten Befestigungsöffnung (21) und der zweiten Befestigungsöffnung (22) verläuft, einstückig und nahtlos aneinander angeordnet sind, die Mittellinie (M) ist damit als First des Oberteils (1) ausgebildet, das Oberteil (1) ist ausgestaltet, dass sich die erste Fläche (F1) ausgehend von der Mittellinie (M) bis zu einer ersten Traufkante (TK1) und die zweite Fläche (F2) ausgehend von der Mittellinie (M) bis zu einer zweiten Traufkante (TK2) jeweils als eine schiefe Ebene erstreckt, wobei in der ersten Fläche (F1) und in der zweiten Fläche (F2) die Anschlüsse (DA1,...,DA8) derart ausgestaltet sind, dass jeweils für einen Anschluss (DA1,...,DA8) in den Flächen (F1,F2) bzw. in dem Oberteil (1) ein Gewinde (G) integriert ist und um das Gewinde (G) ist eine kreisrunde Kontaktfläche (K) in der Ausgestaltung eines Hohl-Zylinders (HZ) angeordnet, der Hohl-Zylinder (HZ) wiederum ist derart in der schiefen Ebene angeordnet, dass seine Symmetrieachse (SA) des Hohl-Zylinders (HZ) vertikal verläuft, wobei dadurch für einen einzuschraubenden Schraubsteckverbinder (S) für den Anschluss (DA1,...,DA8) die Kontaktfläche (K) als eine ebene, ringförmige Kontaktfläche (K) ausgestaltet ist, auf der der Schraubsteckverbinder (S) mit einer hygienegerechten Dichtung abdichten kann.

2. Automatisierungskomponente (10) nach Anspruch 1, wobei der Hohl-Zylinder (HZ) derart in der Fläche (F1,F2) angeordnet ist, dass die Kontaktfläche (K) sowohl zur Seite der Mittellinie (M) als auch zur Seite der Traufkante (TK1,TK2) erhaben aus der Fläche (F1,F2) heraussteht und einstückig mit der Fläche (F1,F2) ausgebildet ist, wobei der Übergang des Hohl-Zylinders (HZ) zur Fläche mit einer Rundung (R) versehen ist.

3. Automatisierungskomponente (10) nach Anspruch 1 oder 2, wobei das Gehäuse (3) und damit das Oberteil (1) und das Unterteil (2) derart ausgestaltet sind, dass sich in einer Vorzugseinbaulage (VE), bei welcher die Befestigungsöffnungen (21,22) senkrecht übereinanderstehen, das Gehäuse (3) ausgehend von der ersten Befestigungsöffnung (21) sich in Richtung der zweiten Befestigungsöffnung (22) verjüngt.

4. Automatisierungskomponente (10) nach einem der Ansprüche 1 bis 3, wobei das Gehäuse (3) derart ausgestaltet ist, dass alle Flächen derart geformt sind, dass Ablagerungen von Verunreinigungen vermieden oder minimiert werden.
